# EUROPEAN PATENT APPLICATION

(11) **EP 1 434 275 A1**
(43) Date of publication of application: **30.06.2004**
(21) Application number: 02767911.7
(22) Date of filing: 06.09.2002
(51) Int. Cl.: H01L 29/786, H01L 21/336, H01L 21/20

(54) **THIN FILM SEMICONDUCTOR DEVICE AND METHOD FOR FABRICATING THE SAME**

(30) Priority: 10.09.2001 JP 2001317414
(71) Applicant: Advanced Lcd Technologies Development Center Co., Ltd., Yokohama-shi, Kanagawa 244-0817 (JP)
(72) Inventor: OANA, Yasuhisa, c/o Advanced LCD Technologies, Yokohama-shi, Kanagawa 244-0817 (JP); MATSUMURA, Masakiyo, c/o Advanced LCD Technologies, Yokohama-shi, Kanagawa 244-0817 (JP)
(74) Representative: KUHNEN & WACKER
(86) International application number: PCT/JP2002/009090
(87) International publication number: WO 2003/023866

(57) **Abstract**

The thin film semiconductor device of the present invention includes a gate electrode insulator, which is formed through high-heat oxidization of semiconductor film. The high-heat oxidization of semiconductor film is carried out, in the process of crystallization or recrystallization of non-single- crystalline semiconductor thin film on a base layer, by irradiating predetermined areas of the thin film which is implanted with oxygen ion before irradiation, to convert such areas to oxidized areas, and these areas are processed to gate electrode insulators of electric circuit units in the thin film semiconductor device. The device has advantages in greatly reducing the fluctuation of operational threshold value and increasing the stability of device. When irradiation of energy beam is carried out in a specified mode, the thin film semiconductor device having a high nobility, in which unit electric circuit are arranged regularly in accordance with the arrangement of semiconductor crystal grains, is obtained.

## Description

### Background of the invention

The present invention relates to a thin film semiconductor device and a semiconductor substrate sheet to be used in the semiconductor device as well as a method for producing them.

As is well known, a thin film semiconductor device or thin film transistor (TFT) comprises a substrate, in which a thin film layer of semiconductor materials such as silicon is formed on a base layer of insulation materials such as non-alkaline glass, or quarts glass. In the thin film layer of semiconductor, a plurality of channels consisting of a source area and a drain area are formed and each of channels is equipped with a gate electrode separated by an insulating film from the above areas.

In the above thin film semiconductor device, a gate electrode insulator is interposed between the gate electrode and the channel area, The insulator is usually formed with a film of silicon oxide, and this film is usually required to be formed at a low temperature. Therefore, in forming the above silicon oxide film, such silicon oxide film formation technique such as used in LSI producing process, in which a high temperature more than 900°C is required, cannot be used. In instead, a low temperature deposition process using plasma CVD method, which is carried out at a temperature lower than 600°C, is used.

However, an oxidized film deposited by the plasma CVD method has disadvantages in insulation property or stability compared with a film oxidized at high temperature. That is, when using the plasma CVD method, some impurities remain between the channel area and the gate insulator film, and further, the produced film of silicon oxide has a tendency to be composed of such compounds as which do not have a stoichiometrically regulated composition of "SiO₂" but have an irregular composition such as "SiO_{1.9}". When an oxidized film having the above disadvantages is used as a gate electrode insulator of a TFT, the TFT circuit tends not only to have greater variance of threshold voltage value but also to make it difficult to maintain a long term stability of TFT properties. For example, in conventional products, variation of TFT threshold value is usually ±0.4V and such variation becomes great in the period for long time use.

Furthermore, in conventional thin film semiconductor devices using poly-crystalline silicon, disadvantages due to the small size of crystal grains and the irregularity of configuration mode of crystal grains are inevitable. That is, as a poly-silicon film is composed of a numerous crystal grains of extreme small size, the improvement of mobility is limited due to such phenomenon as dispersion of electrons or holes at boundaries between crystal grains at the time of operation of the device.

Thus, it has been tried to obtain a substrate having a thin film layer which makes it possible to increase mobility by avoiding disadvantageousness such as electron dispersion, by means of making the size of polycrystalline silicon to be large. For instance, it has been tried to obtain a thin film layer having a semiconductor grains of about 1 µm size and having a mobility of about 100 cm²/ V sec., by annealing a layer of polycrystalline silicon in a high temperature furnace. However, the above process has a disadvantage that inexpensive glass sheets such as sodium glass sheets cannot be used and expensive quartz glass sheets which can bear high temperature should be used, as the process requires an annealing by extreme high temperature such as over 1000°C. A substrate using such expensive materials is not suited for producing a device of wide size screens in view of costs.

Some other processes has been proposed in order to obtain a thin layer which consists of polycrystalline semiconductor of large size grains, by means of irradiating a thin film of amorphous or polycrystalline semiconductor with an energy beam such as excimer laser, instead of using high temperature annealing. By this irradiation method, it is possible to enlarge the size of a crystal grain in the case where inexpensive glass sheets is used as the base layer.

Nevertheless, even by the method using irradiation of eximer laser, the size of obtained crystal grain generally does not exceed 1 µm and it is inevitable that sizes of grains become uneven. Incidentally, the grain size can be determined by " (the maximum diameter of a grain + the minimum diameter of the grain)÷2" and such diameters can be measured through SEM observation of crystal grains which remains after etching the film by Secco etching process.

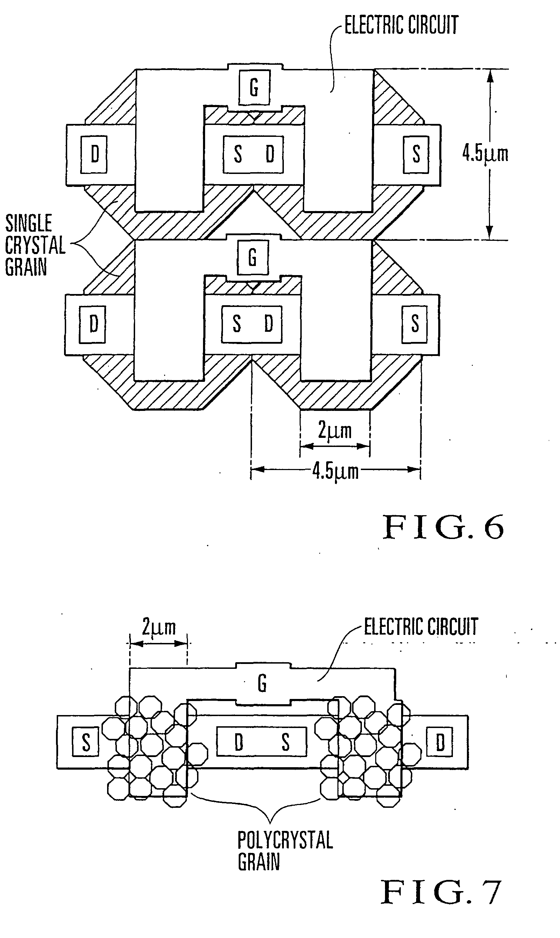

Furthermore, there is a problem on the configuration of crystal grains in a thin film. Namely, in the conventional polycrystalline semiconductor thin film, configuration of crystal grains in the two dimensional direction is extremely random as shown in Fig.7, and it has not been tried to adjust such irregular configuration. The random configuration of crystal grains and the non-uniformity of grain size tend to cause serious difficulty on the devices in which thin film transistors are used. That is, mobility may fluctuate according to the frequency of traversing the border of crystal grains, and it is difficult to integrate a plurality of TFT circuits having different channel lengths.

Accordingly, many TFT on the market, in which poly-crystalline semiconductor film are used, is designed so that one circuit extends so as to contain at least several boundaries of crystal grains as mentioned in Fig.7, in order to reduce the variation of mobility. In such devices, the average mobility cannot exceed 150 cm²/V·sec.

### Disclosure of the Invention

It is an object of the present invention to provide a thin film semiconductor device and a substrate sheet to be used in forming the TFT device, wherein the chemical connection between the semiconductor film and the gate electrode insulator film are successive through border faces and the compounds in gate electrode insulator film has a stoichiochemical composition of SiO₂. The device can avoid the disadvantages of conventional TFT, which is produced by CVD method and has disadvantages due to the character of the oxidized film. Further, the device can reduce greatly the variety of threshold value and maintain a stable operation for a long time.

It is another object of the present invention to provide a thin film semiconductor device and its substrate sheet, in which, in addition to the above stated character, an electric circuit module is not arranged over many crystal grains of various sizes and of disordered configuration, but is so arranged as to have a configuration corresponding to the arrangement of crystal grains.

It is a further object of the present invention to provide a method suited for producing a thin film semiconductor device and its substrate sheet to which have properties and characters stated in the foregoings.

Inventors of the present invention has found that a thin film semiconductor device can work stably for a long time with such excellent properties as stated above and with reduced fluctuation in operational threshold value, when a partial region in the thickness direction of the thin film of semiconductor, after being converted to an oxidized film through irradiation of energy beam, is used as the gate electrode insulator of the device. Also, the inventors has found that a thin film semiconductor device can have a constitution where every unit circuits are arranged corresponding to the arrangement of crystal grains, when the above substrate sheet is produced such that single-crystalline semiconductor grains are arranged regulatedly in a mode such as substantially geometric arrangement.

The substrate sheet for thin film semiconductor device according to the present invention has a feature in that the sheet comprises, a thin film semiconductor having a layer of semiconductor crystal grains formed by crystallization or recrystallization of non-single-crystalline semiconductor layer and a layer of oxidized semiconductor formed by oxidization of non-single-crystalline semiconductor layer. The layer of semiconductor crystal grains may have a configuration in which single crystalline semiconductor grains are arranged in a regular arrangement.

The thin film semiconductor device according to the present invention has a feature in that the device comprises a thin film of semiconductor having two kinds of layer therein, namely, a layer of semiconductor crystal grains and a layer of oxidized semiconductor formed by oxidization of non-single-crystalline semiconductor layer, and the above oxidized semiconductor layer being used as the insulator for the gate electrode. The above layer of semiconductor crystal grains is preferred to have such composition that single-crystalline semiconductor grains are arranged in a regulated arrangement.

The method for producing a substrate sheet for thin film semiconductor devices according to the present invention has a feature in comprising steps of; (a) depositing a layer of non-single-crystalline semiconductor on a base layer of insulation materials, (b) forming oxygen implanted areas in the non-single-crystalline semiconductor layer by implanting oxygen ion into the layer and (c) irradiating the layer with energy beam, thereby changing the layer of non-single-crystalline semiconductor so that the oxygen implanted areas are converted to insulating oxidized films and other areas are converted to films of semiconductor crystal grains. It is preferred that the irradiation of energy beam is carried out so that areas to which the maximum irradiation intensity is given and areas to which the minimum irradiation intensity is given are arranged in a regulated mode and the transition of irradiation intensity between the above two areas is successive.

The method for producing a thin film semiconductor device has a feature in comprising steps of (a) depositing a layer of non-single-crystalline semiconductor on a base layer of insulation materials, (b) forming oxygen implanted areas in the layer of the non-single-crystalline semiconductor by implanting oxygen ion into the layer, (c) irradiating the layer with energy beam, thereby changing the layer of non-single-crystalline semiconductor such that the oxygen implanted areas are converted to insulating oxidized films and other areas are converted to films of semiconductor crystal grains, (d) forming a gate electrode by using the insulating oxidized films as a gate insulator and, (e) completing an electric circuit unit by forming a source electrode and a drain electrode in the layer of semiconductor crystal grains. It is preferred that the irradiation of energy beam is carried out so that areas to which the maximum irradiation intensity is given and areas to which the maximum irradiation intensity is given are arranged in a regulated mode and the transition of irradiation intensity between the above two areas is successive.

The use of substrate sheet according to the present invention makes it possible to produce a thin film semiconductor device according to the present invention which can be operated stably for a long term showing few fluctuation of threshold voltage, as the substrate has an oxidized layer which is formed by oxidizing an amorphous or polycrystalline semiconductor layer and can be used as an insulation film for gate electrode of a thin film semiconductor device,

In the case where the substrate sheet according to the presention having the oxidized layer, is further provided with a layer of semiconductor crystal grains in which single-crystalline grains are arranged regularly, it becomes possible to produce a thin film semiconductor device according to the present invention which has a high mobility and reduce disadvantages due to dispersion of electron, in addition to the reduction of threshold voltage value and the stable operation for a long term.

The method for producing a substrate sheet according to the present invention makes it possible to produce a substrate sheet which has an oxidized layer formed in a thin film semiconductor layer, by implanting oxygen ion into a thin film semiconductor layer formed over a base layer of insulation materials and irradiating the implanted area with energy beam.

The method for producing the thin film semiconductor device according to the present invention the above-mentioned substrate sheet is used, makes it possible to produce a thin film semiconductor device which shows few fluctuation of threshold voltage value and can be operated stably for a long term, as the process has a step to form a gate electrode insulation film using the oxidized layer in the substrate sheet.

The method for producing a substrate sheet according to the present invention further makes it possible also to produce a substrate sheet which has a layer in which single-crystalline grains of large size are arranged regularly, in the case where the step for irradiation of energy beam is carried out so that the areas of maximum strength irradiation and the areas of minimum strength of irradiation are arranged regularly in the direction of two dimentions.

The method of producing a thin film semiconductor device according to the present invention where the aforementioned substrate sheet is used makes it possible to produce a semiconductor device which has a high mobility and can reduce advantages due to dispersion of electron, by forming gate electrode and source/drain areas at each single-crystalline grains which are arranged regularly.

### Brief description of drawings

Fig. 1 is pattern diagrams showing steps of one embodiment of the process according to the present invention for manufacturing a thin film semiconductor device.
Fig.2 is pattern diagrams showing steps of another embodiment of the process according to the invention for manufacturing a thin film semiconductor device.
Fig.3 is a pattern diagram for illustrating one embodiment of distribution of energy beam intensity in two-dimensional directions in the irradiation step according to the process of the present invention.
Fig.4 is a pattern diagram illustrating a profile of transition of energy beam intensity between a maximum value and minimum value in the process according to the present invention, being shown as a sectional view along the arrow-mark in Fig.3.
Fig.5 is a pattern diagram illustrating an alignment state and growth direction of single crystalline grains during and after the irradiation of energy beam in the process according to the present invention.
Fig.6 is the pattern diagrams illustrating one embodiment of the positional relationship of electrodes with crystal grains in the thin film semiconductor device of the present invention.
Fig. 7 is a pattern diagram illustrating one embodiment of the positional relationship of electrodes with crystal grains in a thin film semiconductor device using a conventional thin film of polycrystal semiconductor.

### Description of preferred embodiments

To form the thin film semiconductor device of the present invention, it is preferred to use a glass sheet having a strain point not exceeding 700°C as the material of base layer of substrate sheet. But, it is possible to use various kinds insulation materials other than glass, for example, ceramics or plastic films having appropriate heat resistance.

On the above base layer, the single crystalline semiconductor film, in which an oxidized insulation film located on top of a single-crystalline film or in an intermediate portion in the thickness direction of the single crystalline film, is formed. This semiconductor thin film can be produced by implanting oxygen ion into a non-single- crystalline semiconductor film deposited on a base layer and then irradiating it with an energy beam such as eximer laser, thereby changing the above non-single -crystalline semiconductor film to a semiconductor film composing of a oxidized film and a layer of single-crystalline grains of large size. As the above non-single-crystalline semiconductor, both of amorphous semiconductor and poly-crystalline semiconductor in which small size crystal grains are already formed, can be used. In using the latter, the poly-crystalline semiconductor is changed to a semiconductor film of the present invention by implantation of oxygen ion and recrystallization. The thickness of amorphous semiconductor film is preferred to be 30 through 300 nm, especially 30 through 200 nm.

Usually, when a semiconductor layer of the above non-single crystalline character is formed on the base layer, a thin control layer for adjusting heat-conduction and crystallization consisting of such materials as silicon oxide or silicon nitride (SiNx), is formed between the base layer and the semiconductor layer. This layer has such functions as to block the diffusion of impurities such as glass components from the base layer to the semiconductor layer and to bring the uniformity of heat distribution in the semiconductor layer by controlling the orientation of crystallization. The thickness thereof is desired to be 20 through 1000nm, especially 200 through 300nm.

It is also usual to form the second control layer for adjusting heat-conduction and crystallization further on the above non-single-crystalline semiconductor layer (the first control layer). This second control layer has a function same as the first control layer, namely, to bring the uniformity of heat distribution and to control the orientation of crystals in the semiconductor layer in the process of crystallization by irradiation. Materials such as silicon-oxide, silicon-nitride, silicon-ox-nitride or silicon-carbonate (SiC) can be used therefor. The thickness of the layer is desired to be 50 through 500nm, especially 100 through 300nm.

The thin film semiconductor layer may be formed between the two control layers. In this case, firstly the material of the first control layer is deposited as a thin film on the base layer of insulation material, then, the material of thin film of non-single-crystalline semiconductor is deposited on the first control layer, and further, the material of the second control layer is deposited on the above semiconductor layer. Thereafter, the irradiation of energy beam from the upper direction is carried out to crystallize or recrystallize the layer of non-single crystalline material.

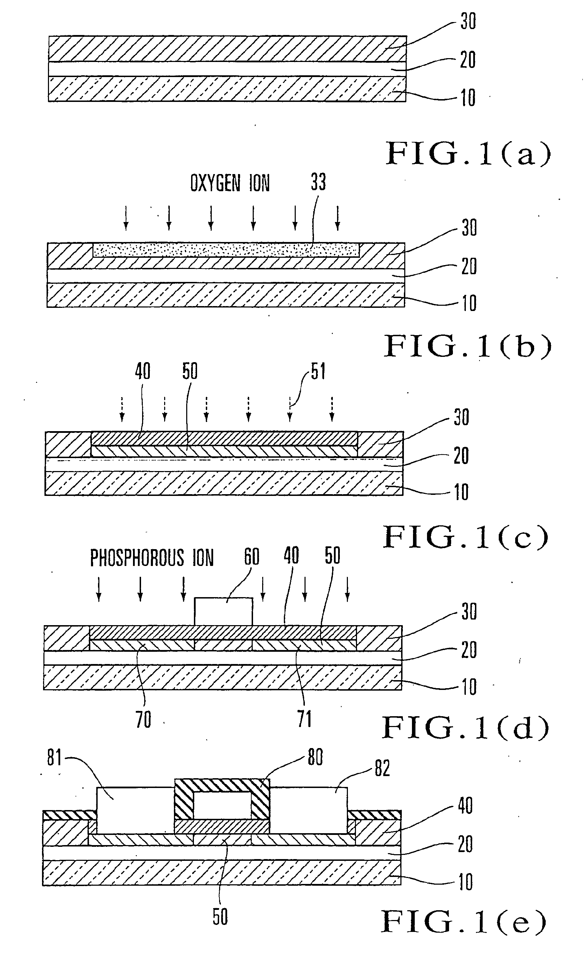

Fig. 1 (a) through Fig. 1 (e) show one embodiment of each stage from deposition of on a base layer to completion of a thin film semiconduction device of present invention. In this embodiment, oxygen ions are implanted to the top surface of non-single-crystalline semiconductor layer.

Referring to Fig. 1 (a), the first control layer 20 for heat conduction and crystallization is deposited on the glass base layer 10, and further, non-single-crystalline semiconductor layer is deposited thereon. Next, as shown in Fig. 1 (b), oxygen ion is implanted into a predetermined area to form an oxygen implanted area 33. As shown in Fig. 1(c), the above predetermined area is irradiated with an energy beam to form an oxidized layer 40, which is formed through high-heat oxidization of oxygen implanted area by an energy beam, and to form a single-crystalline semiconductor grains layer 50 which is formed through single-crystallization of non-single-crystalline layer 30. The area which is not irradiated by energy beam remains as a non-single-crystalline area 40. Incidentally, Figs. 1(c) and 1(d) show the sectional view of single area of single-crystalline grains layer. It is of course that the actual substrate sheet has a plurality of such oxidized area and single-crystalline grains area.

Next, as shown in Fig. 1 (d), the gate electrode 60 is formed on the oxidized layer 40, which has been formed by irradiation of energy beam, by using the layer 30 as the gate electrode insulator. Then, source area 70 and drain area 71 are formed by implanting a material to form electrode such as phosphorous ion into single-crystalline semiconductor layer 50 using gate electrode 60 as a mask. Following this, as shown in Fig. 1 (e), a film 80 of insulation material such as silicon oxide is deposited so as to surround the upper side and the lateral side of gate electrode 60. Then, after forming contact holes in insulating film 80 at the positions corresponding to source area 70 and drain area 71, source electrode 81 and drain electrode 82 are formed by depositing a material such as aluminum to form an electrode, Thus completing the thin film semiconduction device is completed.

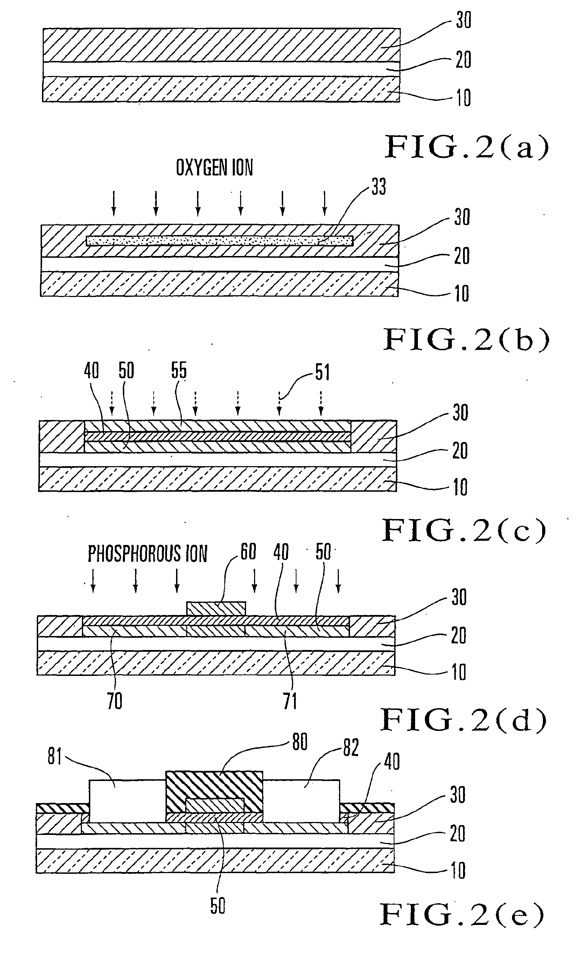

Fig.2 (a) through Fig.2 (e) are pattern diagrams showing an embodiment of the present invention, wherein oxygen ions are implanted into an intermediate layer portion of non-single semiconductor layer.

In this embodiment, the deposition of the first control layer for heat-conduction and the non-single semiconductor layer in the step (a) are carried out by substantially the same way as in the embodiment of Fig. 1. However, the implantation of oxygen ion is made into the intermediate layer portion of the non-single-crystalline semiconductor layer 30, and therefore, the oxygen implanted area 33 is formed in a intermediate region in the thickness direction of the non-single semiconductor layer. After formation of oxygen implanted layer 33, in the step(c), the layer 33 is converted to oxidized film layer, and non-single-crystalline semiconductor area which are located at the upper-side and under-side of the oxygen implanted area are converted to single-crystalline semiconductor layers. Next, as shown in Fig.2 (d), the predetermined areas of the upper-side single-crystalline layer is formed as the gate electrode by the patterning process. The operation of process in the step (e) is same as in the embodiment of Fig. 1.

The volume of oxygen ion (dose) and its implanting depth (Rap) may be determined according to the thickness or position of oxidized insulation layer. The means for irradiation of energy beam is not be limited to the use of excimer laser. For instance, an argon laser radiated continuously can be used by pulsating or scanning it.

In order to obtain a thin film semiconductor layer in which single crystalline semiconductor grains are arranged in a regulated alignment mode by irradiation of energy beams, the irradiation should be carried out in such energy intensity distribution mode as in which the irradiation energy intensity changes successively in two-dimensional directions between the maximum value and the minimum value at predetermined intervals, and maximum points and minimum points appear one after another in a regulated order. In other words, the irradiation should be carried out so that irradiated points to which maximum irradiation intensity is given and irradiated points to which minimum irradiation intensity is given are arranged in a regulated configuration such as a matrix-arrayed configuration.

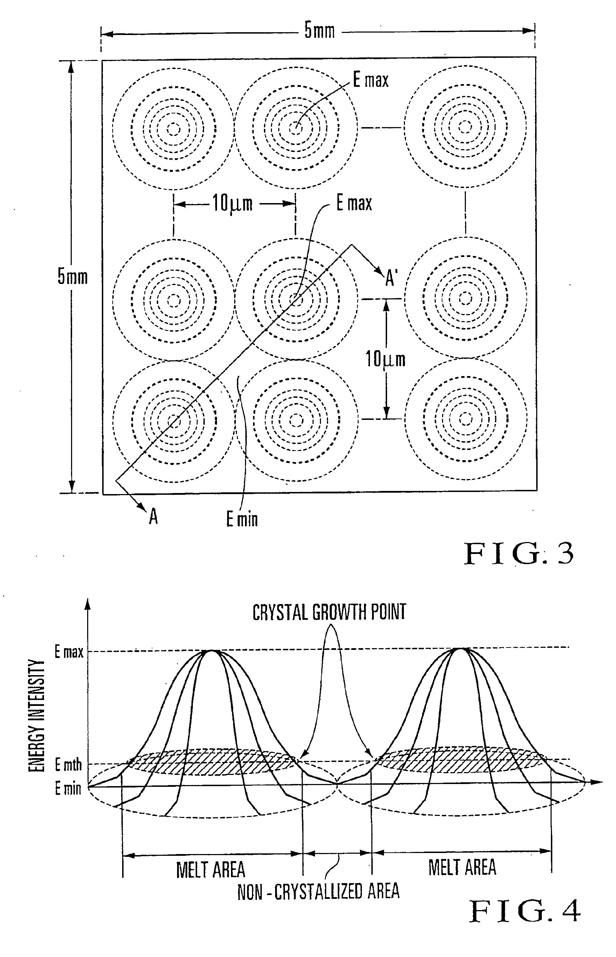

For example, as shown in Figs.3 and 4, the irradiation is carried out in the intensity distribution mode in which irradiation energy repeats such change as "maximum value (Emax)→minimum value(Emin)→maximum value(Emax)". This changing pattern occurs two-dimensionally(in the x, y both directions)in a rectangle region of 5 x 5mm, at every intervals of 10 µ m. In order to making the irradiation to the whole necessary surface of the substrate, the irradiated area (for example, the above square area of 5mm × 5mm) is shifted periodically in either x direction or y direction at a predetermined pitch.

The above change of irradiation energy intensity can be realized by bringing the variation to the irradiation energy intensity distribution, using a phase shift mask. And, it is desirable that the change between the maximum value and the minimum value is a successive change substantially as shown in Fig.4.

Determination of the degree of the maximum value and the minimum value may be based on the film thickness of the non-single-crystalline semiconductor layer and the thermal conductivity of the first and the second control layers. For example, the minimum energy intensity may be determined to be an intensity which the thin film semiconductor does not melt during the irradiation, and the maximum value may be an intensity sufficient to melt the thin film semiconductor during the irradiation. A melting threshold level (Emth) should be positioned between the maximum value (Emax) and the minimum value (Emin), as shown in the Figure 4.

That the face shape of the irradiation beam is not limited to a square shape of 5 × 5mm as mentioned above and may be various polygon shapes. Further, the arrangement mode of maximum value points and minimum value points is not limited to the rectangular lattice. Other shapes, such as delta shaped lattice, also can be used.

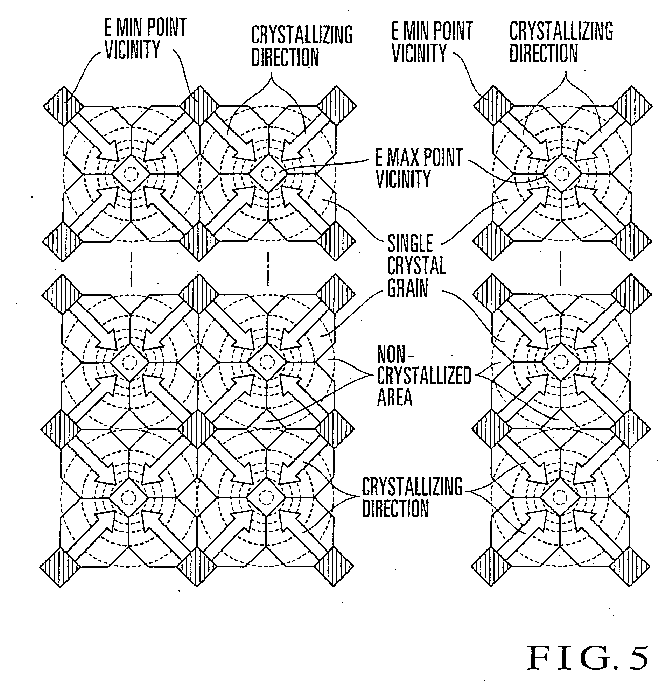

By carrying out the irradiation of energy beam to the semiconductor film in the manner as stated above, the semiconductor layer does not completely melt in the minimum irradiation energy areas (namely, areas to which irradiation energy less than threshold value are given), and fine crystals of semiconductor are produced firstly in the areas near the threshold value areas. Some of these fine crystals functions as cores for crystallization and the crystallization progresses dimensionally (in the direction of arrow marks in Fig.5) from the points of these cores towards the areas, to which maximum irradiation energy are given. In the areas near the threshold value energy are given, at the same time of formation of fine crystal grains, two atoms of oxygen and one atom of silicon are bonded chemically and the formation of SiO₂ layer starts. The growth of this layer also proceeds horizontally with the progress of crystallization of melted silicon.

In the areas in which the temperature of semiconductor film is highest by given with the highest irradiation energy or the areas in which the horizontal growth of crystallization proceeds, a plurality of crystals which have different or crossed crystallization growth direction collide with one another, and their contacting areas form the area of fine crystals or the borderline of crystals. Thus, when the energy beam which has a energy intensity distribution as shown in Figs 3 and 4 is irradiated, a substrate for thin film semiconductor devices in which single-crystalline grains having the size of over 4 µm and covered with insulation film surface are arranged in a regulated mode can be obtained. That the maximum size can be adjusted by adjusting intervals between maximum irradiation energy points. Further, by varying the amount of oxygen ion to be implanted or by changing the position of implantation, the thickness and position (for example, at the surface area or inside area) of oxidized layer can be varied.

Following this process, on each of single crystalline grains in the thin film semiconductor substrate sheet obtained by the process as mentioned above, the electrode materials such as Molybdenum-Tungsten alloy (MoW) is deposited with an appropriate thickness (for example, 300nm), thereby forming a gate electrode. Then, after forming a source area and a drain area respectively using the gate electrode as the implantation-mask, an isolating-interlayer with insulation materials such as silicon oxide, which covers the gate electrode, is formed. Further, after forming contact holes by perforating through the second control layer at the position above the source area and the drain area, electrode materials such as Aluminum/Molybdenum are deposited and patterned in the contact hole.

Thus, as shown in (a) and (b) of Fig6, a thin film semiconductor device, in which one unit electric circuit is arranged in each of a single crystal, can be obtained. A thin film semiconductor device of this type can have a high mobility (for example, over 300cm²/V.sec) exceeding the mobility of conventional devices in which a substrate sheet comprising polycrystalline semiconductor film is used.

When an oxidized film, is formed by implantation of oxygen ions into non-single crystalline semiconductor layer and together with high-heat oxidation thereof using energy beam irradiation to form the gate insulator, the variety of threshold voltage value (Vth) of thin film semiconductor device can be greatly reduced (to the degree of less than 0.1 V) compared with conventional devices. Also, the stability of threshold value related to contamination of gate insulator or channel boundaries is greatly improved to such degree that the shift amount of Vth after 10,000 hours operation is reduced to less than 0.05 V

The main reason of these improvement is that the oxidized insulation film has a solid and minute character as same with a heat-oxidized silicon film, due to its high-heat formation process including melting step. For example, this oxidized film has the property as same with the heat-oxidized silicon film in the value of flat band voltage obtain by leak current measurement or C-V measurement, or in the shift amount of threshold value in bias temperature stress estimation(BTS). Further, this oxidized film layer, not withstanding its thin character, can fully protect the single-crystalline silicon layer and does not cause the breakdown.

It is possible to omit to set the electrode on some predetermined grains of single-crystalline, or to set plural electric circuits to one single crystalline grain, if necessary. Though the process for setting electric circuit stated in the foregoings corresponds to the process for a thin film transistor of N-channel type, it is possible to apply the process for a CMOS transistor by implanting impurities successively with using partial masking means. Furthermore, it is possible to use the second control layer as an accumulated gate insulator directly or to use only the insulating oxidized film as the gate insulating layer after making etching-treatment. If it is apprehended that the leak currents may occur among the adjacent transistors, islands separation can be made by etching after or before the crystallization.

### [Examples]

On the surface of non-alkali glass sheet, manufactured by Corning Glass Works, with the outside dimension of 400 × 500 mm, the thickness of 0.7 mm and the strain point of 650°C, a layer of silicon oxide (SiO₂) with thickness of 200 nm was deposited by the method of plasma CVD, as the first control layer for heat-conduction and crystallization. Then, a layer of amorphous silicon (a-Si:H) with thickness of 60 nm was deposited without being exposed to the atmosphere. Next, this layer of amorphous semiconductor was annealed, and after dehydrogenating it, the surface area of the layer is formed as an oxygen-implanted area by implantation of oxygen ion. The implantation of oxygen ion was carried out with the accelerated voltage of 3 keV, and the dose amount of 1.5E17/cm². Under these conditions, the position of the maximum oxygen density was at the depth of about 10 nm corresponding to ion projection range (Rp), and the maximum density of oxygen was 1E23/cm³.

As stated in the foregoing, the implanting amount of oxygen (dose amount) or the implanting depth of oxygen (Rp) is determined by the thickness of insulating oxidized layer and its position to be formed. In the present example, the above implantation conditions were determined from the viewpoint for forming an insulation oxidized layer of about 30 nm thicknesses on the surface of a layer of single-crystalline semiconductor.

Sequentially, pulsated laser beam were irradiated to the substrate sheet from its upper-side, whereby the amorphous silicon layer was crystallized and the oxygen implanted layer was converted to an oxidized layer. The irradiation was carried out in a mode that one unit of laser has a square size irradiation face of 5 mm × 5mm in which 250,000 numbers of maximum intensity points and minimum intensity points are arranged with intervals of 10 µm in a square lattice form, by using a phase shift mark for distributing the irradiation strength. In this embodiment, the melting threshold value (Emth) was about 0.6 J/cm², the maximum energy strength of laser beam (Emax) being 1.9 J/cm² and minimum strength value (Emin) being 0.1 J/cm².

By the irradiation process, the layer of amorphous silicon of 60 nm thickness was converted to a layer comprising a crystalline silicon layer of about 50 nm thickness and an oxidized layer of about 30 nm thickness. Implanted oxygen ion of dose amount of 1.5 E17/cm² is reacted with silicon atoms equivalent to silicon layer of 20 nm thickness, and formed a silicon oxide layer of about 30 nm thickness.

The irradiation excimer laser in this process was carried out over the whole surface of the sheet by shifting the irradiation face stepwise at the intervals of 5mm. After finishing the irradiation, a secco-etching treatment was made. As the result of observation by a scanning-type electronic microscope, it was found that a substrate for thin film semiconductor device, in which one million numbers of single-crystalline grains of average size of 4.5 µm were arranged regulatedly in the lattice form in every square areas of 5 × 5 mm.

Next, molybdenum/tungsten alloy layer is deposited by sputtering process, and gate electrodes were formed by patterning the layer to predetermined shapes with adjusting its position so as to corresponding to the position of at every single-crystalline grains. Then, by implanting phosphorous ion with using the gate electrodes as the mask, source electrodes and drain electrodes were formed. Then, layers of silicon oxide were deposited by plasma CVD process for forming insulator. After perforating contact holes in insulators positioned corresponding to source areas and drain areas, aluminum layers are deposited and patterned them, thereby completed a thin film transistor (TFT). This device acted with N-channel operation, showing the threshold voltage (Vth) of 1.2 V and the mobility of 496 cm² /V·sec. When thin film transistors were formed on a thin film semiconductor substrate sheet of 400 mm × 500 mm size, threshold values thereof were 1.2 V±0.08V and the mobility were 496 ± 56 cm²/V·sec. In a BTS estimation of 10,000 seconds, shifting values were only 0.05V

The following is another example, in which the insulating oxidized film layer is embedded into the film of single-crystalline silicon grains.

On the surface of base layer of non alkali glass manufactured by Corning Glass Works, having the dimension of 400mm × 500mm, the thickness of 0.7 mm, and the strain point of 650°C, an oxidized silicon (SiO²) film of 200 nm thickness is formed by plasma CVD method as the first control layer for heat conduction and crystallization. Then, a layer of amorphous silicon (a-Si:H) of 110 nm thickness is formed without exposing to the atmosphere.

The layer of amorphous silicon oxide was annealed and dehydrogenated. Then, oxygen ion was implanted to the intermediate region in the thickness direction in order to form an oxygen implanted area. The implantation of oxygen ion was carried out with the accelated voltage of 20keV and the dose amount of 1.5E17/cm². Under these conditions, the maximum oxygen density point of 3E22/cm³ was positioned in the depth of about 50nm corresponding to the projection range of oxygen ion. The above conditions for implantation area were determined for the purpose of forming an insulating oxidized layer of about 30nm thickness in the depth of about 60nm (central depth) from the surface of single-crystalline grains layer.

Then, the pulsated excimer laser beam was used to irradiate the layer from the upper direction, whereby the amorphous silicon layer was crystallized and the oxygen implanted areas were converted to oxidized areas. The irradiation of laser was carried out with the irradiation intensity distribution by using a phase shifting mask so that a total of 250,000 maximum intensity points and minimum intensity points were formed, being arranged with a square lattice form at intervals of 10 µm in one unit of irradiated face of 5mm × 5mm. In this example, melting threshold value (Eth) was about 0.8J/cm², the maximum value of energy intensity (Emax) was 2.3J/cm² and the minimum intensity value was 0.1J/cm². By the above irradiation, the amorphous silicon layer of 110nm thickness was changed to three layers, namely, the second single-crystalline silicon grains layer at the top area with 45nm thickness, the oxidized silicon layer of about 30nm at the intermediate area and the first single-crystalline grains layer of about 50nm at the bottom area.

Next, the second single crystalline silicon layer 55 was formed as a gate electrode by patterning, and source area and drain area were formed by implanting phosphorous ion with using the gate electrode as mask. Following this, silicon oxide layer was deposited as an insulator using a plasma CVD deposition method and contact holes were formed in the insulator at the position above the source and drain areas. The thin film transistor (TFT) is then completed by depositing aluminum and patterning it. This process results in a N channel device with a threshold voltage value (Vth) of 1.0V and an electron mobility of 475 cm²/V·sec.

The threshold values of 20 numbers of thin film transistors, each of which was formed on the thin film semiconductor base layer of 400nm × 500nm, were 1.0±0.08 V, and the mobilities thereof were 475±50 cm²/V· sec. Furthermore, by the BTS estimation of 10,000 seconds, shift amount of Vth was only 0.05 V

In the above examples, the oxidize layer is formed by implanting oxygen ion. However, the layer can be formed by further introducing other ions such as nitrogen ion.

## Claims

1. In a substrate sheet for thin film semiconductor devices comprising a base layer of insulation materials and a thin film layer of semiconductor formed on the base layer, the substrate **characterized in that** said thin film layer of semiconductor comprises a layer of semiconductor crystalline grains which is formed by crystallizing or re-crystallizing a layer of non-single-crystalline semiconductor and an oxidized layer which is formed by oxidizing the layer of non-single-crystalline.

2. A substrate sheet for thin film semiconductor devices of Claim 1, wherein a plurality of single-crystalline grains are arranged in a regulated mode in the layer of crystalline semiconductor.

3. A substrate sheet for thin film semiconductor devices of Claims 1 or 2, wherein the thin oxidized layer formed by oxidation of non-single-crystalline semiconductor layer is formed as a top layer of the thin film semiconductor layer.

4. A substrate sheet for thin film semiconductor devices of Claim 1 or 2, wherein the thin oxidized layer formed by oxidation of non-single-crystalline semiconductor layer is formed as an intermediate layer in the thin film semiconductor layer.

5. A substrate sheet for thin film semiconductor devices of Claim 1 or 2, wherein the grain size of single-crystalline semiconductor is at least 2 µm.

6. A substrate sheet for thin film semiconductor devices of Claim 1 or 2, wherein a control layer for heat-conduction or crystallization is formed between the base layer of insulation material and the thin film semiconductor layer.

7. In a thin film semiconductor device comprising a base layer of insulation material and a thin film layer of semiconductor formed on the base layer, the device **characterized in that** said thin film semiconductor layer comprising a layer of semiconductor crystal grains formed by crystallization or recrystallization of non-single-crystalline semiconductor layer and an oxidized layer formed by oxidization of said non-single-crystalline semiconductor layer and, the area of said thin oxidized layer constituting a insulator of gate electrode.

8. A thin film semiconductor device of Claim 7,wherein semiconductor crystal grains are arranged in a regulated mode in the layer of single-crystalline semiconductor.

9. A thin film semiconductor device of Claim 7, wherein the grain size of single-crystalline semiconductor grains formed in the layer of single crystalline semiconductor grains is at least 2 µm.

10. A thin film semiconductor device of Claim 7, wherein a control layer for heat conduction and recrystallization is formed between the base layer of insulation materials and the thin film semiconductor layer.

11. In a method for producing a substrate sheet for thin film semiconductor devices comprising steps of, forming a thin film semiconductor layer of non-single-crystalline semiconductor on a base layer, and crystallizing the non-single-crystalline semiconductor by irradiating the thin film semiconductor layer with energy beam; the method **characterized in** comprising steps of;
(a) depositing a layer of non-single-crystalline semiconductor on a base layer of insulation materials,
(b) forming oxygen implanted areas in the layer of non-single-crystalline by implanting oxygen ion into the layer, and
(c) irradiating the layer of non-single-crystalline semiconductor with energy beam, thereby changing the layer of non-single-crystalline semiconductor so that the oxygen implanted areas are converted to insulating oxidized films and other areas are converted to films of semiconductor crystal grains.

12. A method for producing a substrate for thin film semiconductor devices of Claim 11, wherein the irradiation of energy beam is carried out so that the area to which the irradiation intensity of maximum value is given and the area to which the irradiation intensity of minimum value is given are arrange d in a regulated mode and the transition of irradiation intensity between the above two areas are successive.

13. A method for producing a substrate sheet for thin film semiconductor devices of Claim 11, wherein the minimum value of irradiation intensity is the intensity which does not cause the melt of the non-single -crystalline semiconductor.

14. A method for producing a substrate sheet for thin film semiconductor devices of Claim 11, wherein the oxygen implanted areas are formed in the top layer portion of non-single-crystalline semiconductor layer.

15. A method for producing a substrate sheet for thin film semiconductor devices of claim 11, wherein the oxygen implanted areas is formed in the intermediate layer portion of non-single-crystalline semiconductor layer.

16. In a method for producing a thin film semiconductor device comprising steps of, producing a substrate sheet by forming a thin film semiconductor layer of non-single-crystalline semiconductor on a base layer of insulation materials and crystallizing the non-single-crystalline semiconductor by irradiating the thin film semiconductor layer with energy beam, and producing a thin film a semiconductor device by forming a electric circuit unit having a gate electrode, source electrode and a drain electrode on the substrate sheet; the method **characterized in** comprising steps of;
(a) depositing a layer of non-single-crystalline semiconductor on a base layer of insulation materials,
(b) forming oxygen implanted areas in the layer of non-single-crystalline semiconductor by implanting oxygen ion into the layer,
(c) irradiating the layer of non-single-crystalline with energy beam, thereby changing the layer of non-single-crystalline semiconductor so that the oxygen implanted areas are converted to insulating oxidized films and other areas are converted to films of semiconductor crystal grains,
(d) forming a gate electrode by patterning the layer of semiconductor crystal grains and using the insulating oxidized films as a gate insulator and,
(e) completing an electric circuit unit by forming a source electrode and a drain electrode in the layer of semiconductor crystal grains.

17. A method for producing a thin film semiconductor device of Claim 16, wherein the irradiation of energy beam is carried out so that the area to which the irradiation intensity of maximum value is given and the area to which the irradiation intensity of are minimum value is given are arranged
in a regulated mode and the transition of irradiation intensity between the above two areas are successive.

18. A method for producing a thin film semiconductor device of Claim 16, wherein the insulating oxidized layer is formed at the top layer portion of thin film semiconductor layer and, the resulted insulating oxidized layer is used as the gate insulator and the source electrode and the drain electrode are formed in the lower layer of crystal grains.

19. A method for producing a thin film semiconductor device of Claim 16, wherein the insulating oxidized layer is formed in the intermediate layer portion of thin film semiconductor layer and, the resulted insulating oxidized layer is used as the gate insulation layer and the source electrode and the drain electrode are formed in the lowest layer of semiconductor grain.
